(19) Europäisches Patentamt
European Patent Office
Office européen des brevets

(11) EP 3 588 726 A1

(12) EUROPEAN PATENT APPLICATION

(43) Date of publication:
01.01.2020 Bulletin 2020/01

(51) Int Cl.:
H02J 3/18 (2006.01)     G01R 31/04 (2006.01)
G01R 31/42 (2006.01)

(21) Application number: 19182210.5

(22) Date of filing: 25.06.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 27.06.2018  US 201862690551 P
18.10.2018  US 201816164026

(71) Applicant: Schneider Electric USA Inc.
Andover, MA 01810-1067 (US)

(72) Inventors:
• MARWALI, Mohammad Nanda Rahmana
Salem, OR 97302 (US)
• BATCH, John Simon
Salem, OR 97302 (US)

(74) Representative: Murgitroyd & Company
Murgitroyd House
165-169 Scotland Street
Glasgow G5 8PL (GB)

(54) **NEUTRAL CONNECTION DETECTION METHOD FOR 3/4 -WIRE ACTIVE FILTERS**

(57)    Aspects of the present disclosure are directed to a power filter controller comprising at least one input configured to receive measurements of electrical characteristics of source power lines from a power source, and to receive measurements of electrical characteristics of load power lines to a load, an output configured to couple to a power converter coupled to the source power lines and the load power lines, and control circuitry coupled to the first input, the second input, and the power converter and configured to provide control signals to the power converter, wherein the control circuitry is configured to detect a connection status of a neutral connection to the load based on at least one of the measurements of the electrical characteristics of the source power lines and the measurements of the electrical characteristics of the load power lines, wherein the connection status includes one of connected and disconnected.

FIG. 2

**Description**

BACKGROUND OF THE INVENTION

1. Field of the Invention

At least one example in accordance with the present invention relates generally to power systems.

2. Discussion of Related Art

The implementation of power filters between a power source and a load is known. For example, active power filters may be coupled in parallel with a load and controlled to actively filter the power from the power source to the load.

SUMMARY

According to at least one aspect of the present invention, a power filter is provided having a first input configured to receive measurements of electrical characteristics of source power lines from a power source, wherein the source power lines include a first phase line, a second phase line, a third phase line and a neutral, a second input configured to receive measurements of electrical characteristics of load power lines to a load, wherein the load power lines include a first phase line, a second phase line, a third phase line and a neutral, an output configured to couple to output power lines to provide output current compensation signals, wherein the output power lines include a first phase line, a second phase line, a third phase line and a neutral, a power converter coupled to the power output and configured to receive input power, receive input control signals and provide the output current compensation signals based on the input control signals, and control circuitry coupled to the first input, the second input and the power converter and configured to provide the control signals to the power converter, wherein the control circuitry is configured to detect a connection status of a neutral connection to the load, wherein the connection status includes one of connected and disconnected.

In one embodiment, the electrical characteristics of the load power lines include phase voltages, and wherein the control circuitry is configured to determine a value of a zero-voltage component of the load power lines, and detect the status of the neutral connection based on the value. In some embodiments, the control circuitry is further configured to adjust the control signals to attempt to change the zero-voltage component, and detect the status of the neutral connection based on a resulting change in the zero-voltage component. In at least one embodiment, the control circuitry is configured to adjust the control signals based on a comparison of the zero-voltage component and a reference zero-voltage command.

In at least one embodiment, the reference zero-voltage command includes a DC pulse. In an embodiment, the power filter further includes a user interface configured to receive a neutral connection setting of the load from a user, and wherein the control circuitry is configured to compare the neutral connection setting of the load with the connection status of the neutral connection to obtain a comparison result, and provide an indication on the user interface of the comparison result. In some embodiments, the control circuitry is configured to adjust operation of the power filter based on the status of the neutral connection.

In embodiments, the controller is further configured to generate the control signals, based on the measurements of electrical characteristics of source power lines from a power source, to correct at least one of harmonic distortion, power factor and load balance created by a load. In one embodiment, the output current compensation signals are AC output current signals, and wherein the power converter is configured to receive input power and to provide the AC output current signals based on the control signals.

According to one aspect, a method of operating a power filter to control characteristics of power from a source to a load is provided, the method comprising receiving measurements of electrical characteristics of source power lines from the power source, wherein the source power lines include a first phase line, a second phase line, a third phase line and a neutral, receiving measurements of electrical characteristics of power lines to the load, wherein the load power lines include a first phase line, a second phase line, a third phase line and a neutral, providing output current compensation signals at output power lines, wherein the output power lines include a first phase line, a second phase line, a third phase line and a neutral, and detecting a connection status of a neutral connection to the load, wherein the connection status includes one of connected and disconnected.

In one embodiment, the electrical characteristics of the load power lines include phase voltages, and wherein the method further includes determining a value of a zero-voltage component of the load power lines, and detecting the status of the neutral connection based on the value. In an embodiment, the method further includes adjusting the control signals to attempt to change the zero-voltage component, and detecting the status of the neutral connection based on a resulting change in the zero-voltage component. In some embodiments, the method further includes adjusting the control signals based on a comparison of the zero-voltage component and a reference zero-voltage command.

In one embodiment, the reference zero-voltage command includes a DC pulse. In some embodiments, the method further includes receiving a neutral connection setting of the load from a user, comparing the neutral connection setting of the load with the connection status of the neutral connection to obtain a comparison result, and providing an indication on the user interface of the comparison result. In at least one embodiment, the method further includes adjusting operation of the power filter based on the status of the neutral connection. In an embodiment, the method further includes generating the control signals, based on the measurements of electrical characteristics of source power lines from a power source, to correct at least one of harmonic distortion, power factor and load balance created by a load.

According to one aspect of the disclosure, a power filter is provided having a first input configured to receive measurements of electrical characteristics of source power lines from a power source, wherein the source power lines include a first phase line, a second phase line, a third phase line and a neutral, a second input configured to receive measurements of electrical characteristics of load power lines to a load, wherein the load power lines include a first phase line, a second phase line, a third phase line and a neutral, an output configured to couple to output power lines to provide output current compensation signals, wherein the output power lines include a first phase line, a second phase line, a third phase line and a neutral, a power converter coupled to the power output and configured to receive input power, receive input control signals and provide the output current signals based on the input control signals, and means for detecting a connection status of a neutral connection to the load, wherein the connection status includes one of connected and disconnected.

In one embodiment, the electrical characteristics of the load power lines include phase voltages, and wherein the method further includes means for determining a value of a zero-voltage component of the load power lines, and detecting the status of the neutral connection based on the value. In an embodiment, the power filter further includes means for receiving a neutral connection setting of the load from a user, for comparing the neutral connection setting of the load with the connection status of the neutral connection to obtain a comparison result, and for providing an indication on a user interface of the comparison result.

According to at least one aspect of the disclosure, a power filter controller is provided comprising at least one configured to receive measurements of electrical characteristics of source power lines from a power source, wherein the source power lines include a first phase line, a second phase line, a third phase line and a neutral, and to receive measurements of electrical characteristics of load power lines to a load, wherein the load power lines include a first phase line, a second phase line, a third phase line, and a neutral, an output configured to couple to a power converter coupled to the source power lines and the load power lines, and control circuitry coupled to the at least one input and the power converter, and configured to provide control signals to the power converter, wherein the control circuitry is configured to detect a connection status of a neutral connection to the load based on at least one of the measurements of the electrical characteristics of the source power lines and the measurements of the electrical characteristics of the load power lines, wherein the connection status includes one of connected and disconnected.

In some embodiments, the electrical characteristics of the load power lines include phase voltages, and wherein the control circuitry is configured to determine a value of a zero-voltage component of the load power lines, and detect the status of the neutral connection based on the value. In some embodiments, the control circuitry is further configured to adjust the control signals to attempt to change the zero-voltage component, and detect the status of the neutral connection based on a resulting change in the zero-voltage component. In various embodiments, the control circuitry is configured to adjust the control signals based on a comparison of the zero-voltage component and a reference zero-voltage command. In at least one embodiment, the reference zero-voltage command includes a DC pulse.

In various embodiments, the power filter controller is coupled to a user interface configured to receive a neutral connection setting of the load from a user, and wherein the control circuitry is configured to receive the neutral connection setting of the load and compare the neutral connection setting of the load with the connection status of the neutral connection to obtain a comparison result, and provide an indication of the comparison result to the user interface. In some embodiments, the control circuitry is configured to adjust the control signals based on the status of the neutral connection.

In at least one embodiment, the control circuitry is further configured to generate the control signals, based on the measurements of the electrical characteristics of the source power lines from the power source, to correct at least one of harmonic distortion, power factor and load balance created by a load. In various embodiments, the controls signals are pulse-width modulation signals, and wherein the pulse-width modulation signals control one or more switches in the power converter.

According to aspects of the disclosure, a method of operating a power filter to control characteristics of power from a source to a load is provided comprising receiving measurements of electrical characteristics of source power lines from the power source, wherein the source power lines include a first phase line, a second phase line, a third phase line and a neutral, receiving measurements of electrical characteristics of power lines to the load, wherein the load power lines include a first phase line, a second phase line, a third phase line and a neutral, providing control signals to a power converter coupled to the source power lines and the load power lines, and detecting a connection status of a neutral connection to the load, wherein the connection status includes one of connected and disconnected.

In various embodiments, the electrical characteristics of the load power lines include phase voltages, and wherein the method further includes determining a value of a zero-voltage component of the load power lines, and detecting the status of the neutral connection based on the value. In some embodiments, the method includes adjusting the control signals to attempt to change the zero-voltage component, and detecting the status of the neutral connection based on a resulting change in the zero-voltage component. In at least one embodiment, the method includes adjusting the control signals based on a comparison of the zero-voltage component and a reference zero-voltage command.

In some embodiments, the reference zero-voltage command includes a DC pulse. In various embodiments, the method includes receiving a neutral connection setting of the load from a user via a user interface, comparing the neutral connection setting of the load with the connection status of the neutral connection to obtain a comparison result, and providing an indication on the user interface of the comparison result. In at least one embodiment, the method includes adjusting operation of the power filter based on the status of the neutral connection. In some embodiments, the method includes generating the control signals, based on the measurements of electrical characteristics of source power lines from a power source, to correct at least one of harmonic distortion, power factor and load balance created by a load.

According to at least one example, a power filter comprising at least one input configured to receive measurements of electrical characteristics of source power lines from a power source, wherein the source power lines include a first phase line, a second phase line, a third phase line and a neutral, and to receive measurements of electrical characteristics of load power lines to a load, wherein the load power lines include a first phase line, a second phase line, a third phase line and a neutral, an output configured to couple to output power lines to provide output current compensation signals, wherein the output power lines include a first phase line, a second phase line, a third phase line and a neutral, a power converter coupled to the power output and configured to receive input power, receive input control signals and provide the output current signals based on the input control signals, and means for detecting a connection status of a neutral connection to the load, wherein the connection status includes one of connected and disconnected.

In various embodiments, the electrical characteristics of the load power lines include phase voltages, and wherein the method further includes means for determining a value of a zero-voltage component of the load power lines, and detecting the status of the neutral connection based on the value. In at least one embodiment, the power filter includes means for receiving a neutral connection setting of the load from a user, for comparing the neutral connection setting of the load with the connection status of the neutral connection to obtain a comparison result, and for providing an indication on a user interface of the comparison result.

BRIEF DESCRIPTION OF THE DRAWINGS

Various aspects of at least one embodiment are discussed below with reference to the accompanying figures, which are not intended to be drawn to scale. The figures are included to provide an illustration and a further understanding of the various aspects and embodiments, and are incorporated in and constitute a part of this specification, but are not intended as a definition of the limits of any particular embodiment. The drawings, together with the remainder of the specification, serve to explain principles and operations of the described and claimed aspects and embodiments. In the figures, each identical or nearly identical component that is illustrated in various figures is represented by a like numeral. For purposes of clarity, not every component may be labeled in every figure. In the figures:

FIG. 1A illustrates a block diagram of a power system according to an embodiment;
FIG. 1B illustrates a block diagram of a power system according to an embodiment;
FIG. 2 illustrates a block diagram of an active power filter according to an embodiment;
FIG. 3 illustrates a block diagram of conventional active power filter control circuitry;
FIG. 4 illustrates a pulse width modulated power converter and filtering network according to an embodiment;
FIG. 5 illustrates a human machine interface according to an embodiment;
FIG. 6 illustrates a block diagram of active power filter control circuitry according to an embodiment;
FIG. 7A illustrates a first signal graph of control signals sent and received by a neutral connection detector according to an embodiment; and
FIG. 7B illustrates a second signal graph of control signals sent and received by a neutral connection detector according to an embodiment.

DETAILED DESCRIPTION OF THE INVENTION

Examples of the methods and systems discussed herein are not limited in application to the details of construction and the arrangement of components set forth in the following description or illustrated in the accompanying drawings. The methods and systems are capable of implementation in other embodiments and of being practiced or of being carried out in various ways. Examples of specific implementations are provided herein for illustrative purposes only and are not intended to be limiting. In particular, acts, components, elements and features discussed in connection with any one or more examples are not intended to be excluded from a similar role in any other examples.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are no intended to limit the presently disclosed systems or methods, their components, acts, or elements. The use herein of "including," "comprising," "having," "containing," "involving," and variations thereof is meant to encompass the items listed thereafter and equivalents thereof as well as additional items.

References to "or" may be construed as inclusive so that any terms described using "or" may indicate any of a single, more than one, and all of the described terms. In addition, in the event of inconsistent usages of terms between this document and documents incorporated herein by reference, the term usage in the incorporated features is supplementary to that of this document; for irreconcilable differences, the term usage in this document controls.

As discussed above, Active Power Filters (APFs) are configured to improve power quality of a three-phase power system. A conventional power system might include a power source, such as a three-phase Alternating Current (AC) power source, and a load, such as a three-phase load. The power source may be coupled to the load via several conductors, including three phase conductors and a neutral conductor.

Power provided by the power source may include undesirable electrical characteristics which decrease the quality of the power. The undesirable electrical characteristics include harmonics, low Power Factor (PF), and an imbalanced fundamental frequency, and may be caused by operation of the power system and/or the load. An APF is typically connected in parallel with the load via one or more conductors, including three phrase conductors and a neutral conductor, to improve the quality of the power. For example, the APF may be configured to sense characteristics of the power provided between the power source and the load, analyze the sensed characteristics, and inject compensation current via the one or more conductors to the load to compensate for low power quality.

In some implementations, each of the one or more conductors of the APF may be coupled to a respective conductor connecting the power source to the load. For example, consider a three-phase load. In one example, the power source may be coupled to the load via three phase conductors and a neutral conductor. The APF may include three phase conductors, each coupled to a respective phase conductor of the three phase conductors connecting the power source to the load, and a neutral conductor coupled to the neutral conductor connecting the power source to the load. In another example, the load may not use the neutral conductor, and the APF will operate using the three phase conductors and no neutral conductor.

In some conventional power systems, a user may be required to specify whether the neutral conductor of the APF is connected or disconnected, and the APF will adjust operation based on the selection made by the user. An incorrect selection (for example, indicating that the neutral conductor of the APF is connected when the neutral conductor of the APF is disconnected) may result in incorrect compensation of the power source by the APF, or instability in the APF control to cause the APF to trip on over current. Accordingly, it may be advantageous to correctly indicate whether the neutral conductor of the APF is correctly or incorrectly selected.

Embodiments of the present disclosure enable detection of a neutral conductor connection of a load coupled to an APF. In one embodiment, a neutral conductor connection status may be detected using a power converter in the APF. For example, the power converter may attempt to inject a zero-component reference current value to reference currents generated by the power converter in the APF. The power converter may analyze the effect of the zero-component reference current on the reference currents generated by the power converter and determine, based on the analysis, the neutral conductor connection status of the APF. The APF may automatically configure one or more neutral conductor connection status settings based on the determination, and may notify a user of an incorrect neutral connection setting.

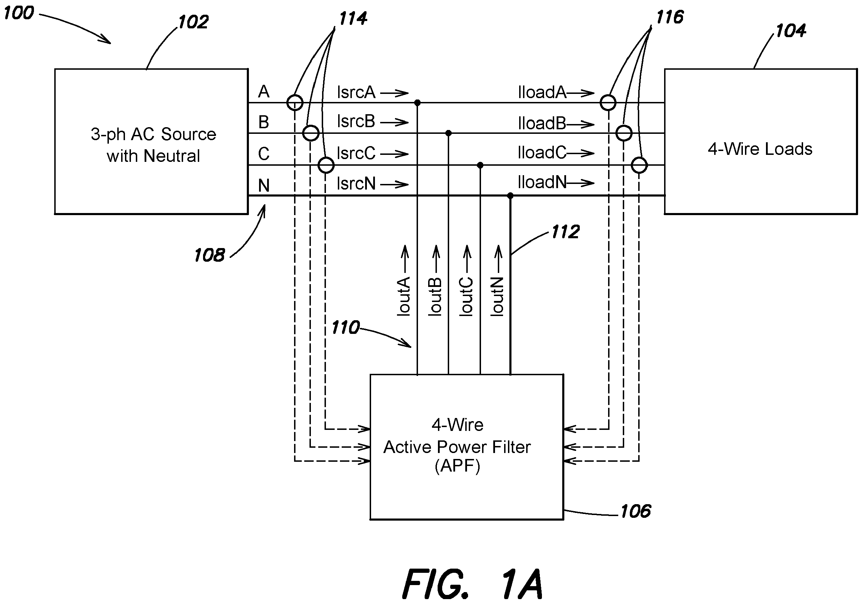

FIG. 1A illustrates a block diagram of a conventional power system 100 according to one example. The power system 100 includes a power source 102, one or more loads 104, and an APF 106. The power source 102 is coupled to the one or more loads 104 via power lines 108, including an A-phase conductor, a B-phase conductor, a C-phase conductor, and a neutral conductor. The APF 106 is coupled to the power lines 108 via power lines 110, including an A-phase conductor coupled to the A-phase conductor of the power lines 108, a B-phase conductor coupled to the B-phase conductor of the power lines 108, a C-phase conductor coupled to the C-phase conductor of the power lines 108, and a neutral conductor 112 coupled to the neutral conductor of the power lines 108.

The power system 100 further includes source Current Transformers (CTs) 114 coupled to the power source 102 and load CTs 116 coupled to the one or more loads 104. Each source CT of the source CTs 114 is coupled to a respective phase conductor of the power lines 108 at an output of the power source 102, and is configured to be communicatively coupled to the APF 106. Each load CT of the load CTs 116 is coupled to a respective phase conductor of the power lines 108 at an input to the one or more loads 104, and is configured to be communicatively coupled to the APF 106.

For example, the source CTs 114 may be configured to sense one or more characteristics of current provided by the power source 102 and provide one or more communication signals indicative of the one or more characteristics to the APF 106. The load CTs 116 may be configured to sense one or more characteristics of current provided to the one or more loads 104, and provide one or more communication signals indicative of the one or more characteristics to the APF 106.

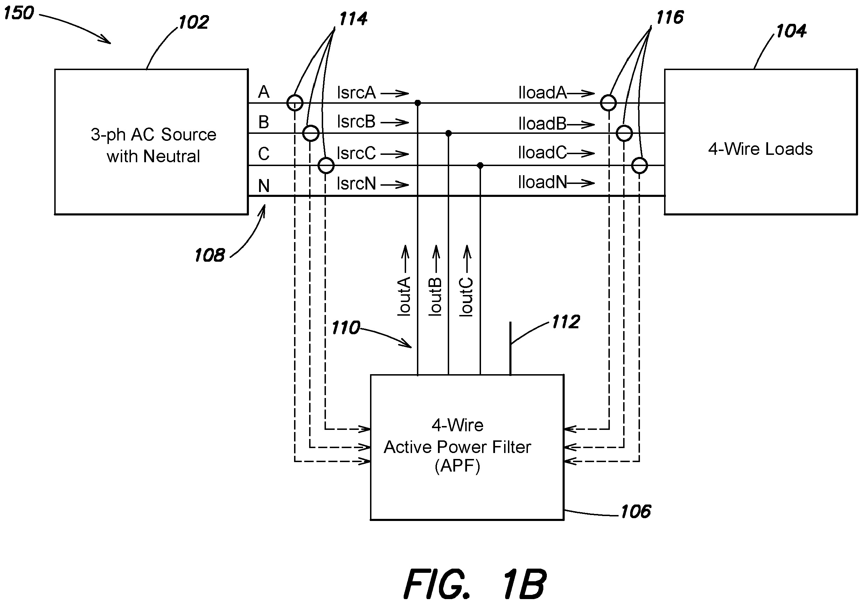

FIG. 1B illustrates a block diagram of a conventional power system 150 according to a second example. The conventional power system 150 includes similar components 102-116 as the conventional power system 100. However, the neutral conductor 112 of the APF 106 is not connected to the neutral conductor of the conductors 108 connecting the power source 102 to the one or more loads 104. As discussed above, a user of the APF 106 may be required to specify whether the neutral conductor 112 is used by the one or more loads 104 to ensure efficient operation of the APF 106.

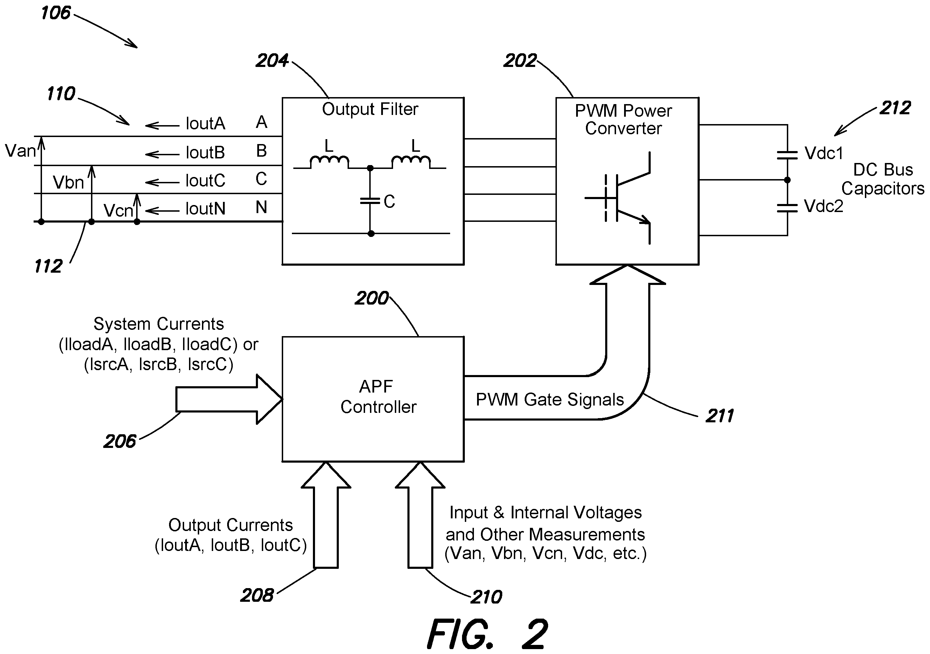

FIG. 2 illustrates a block diagram of an APF 106 in accordance with one embodiment. In the illustrated embodiment. The APF 106 includes APF control circuitry 200, a Pulse Width Modulation (PWM) power converter 202, and an output filter 204. The APF control circuitry 200 receives measurement signals including system current signals IloadA, IloadB, IloadC or IsrcA, IsrcB, IsrcC 206, output current compensation signals IoutA, IoutB, IoutC 208, and input and internal voltage measurement signals Van, Vbn, Vcn, Vdc 210. The system current signals 206 may be received from either or both of the source CTs 114 and the load CTs 116. The signals 208 and 210 may be sensed by one or more sensors coupled to the power lines 110.

The APF control circuitry 200 is configured to receive the signals 206-210, analyze the signals 206-210 to determine a quality of power on the power lines 108, generate one or more PWM gate signals 211, and provide the PWM gate signals 211 to the PWM power converter 202. The PWM power converter 202, which may include one or more Insulated Gate Bipolar Transistors (IGBTs), modulates a state of the IGBTs based on the one or more PWM gate signals 211 received from the APF control circuitry 200 to provide compensation current to the power lines 108. For example, the compensation current provided by the PWM power converter 202 may be derived from one or more DC bus capacitors 212 coupled to the PWM power converter 202. The DC voltage on the one or more DC bus capacitors 212 may be derived from AC power from the power source 102.

The output filter 204 is configured to filter the compensation current received from the PWM power converter 202, and output the compensation current to the power lines 110. Although FIG. 2 illustrates the neutral conductor 112 as providing an output current IoutN, similar to the APF 106 implemented in the conventional power system 100, in alternate embodiments the neutral conductor 112 may not provide an output current IoutN, similar to the APF 106 implemented in the conventional power system 150.

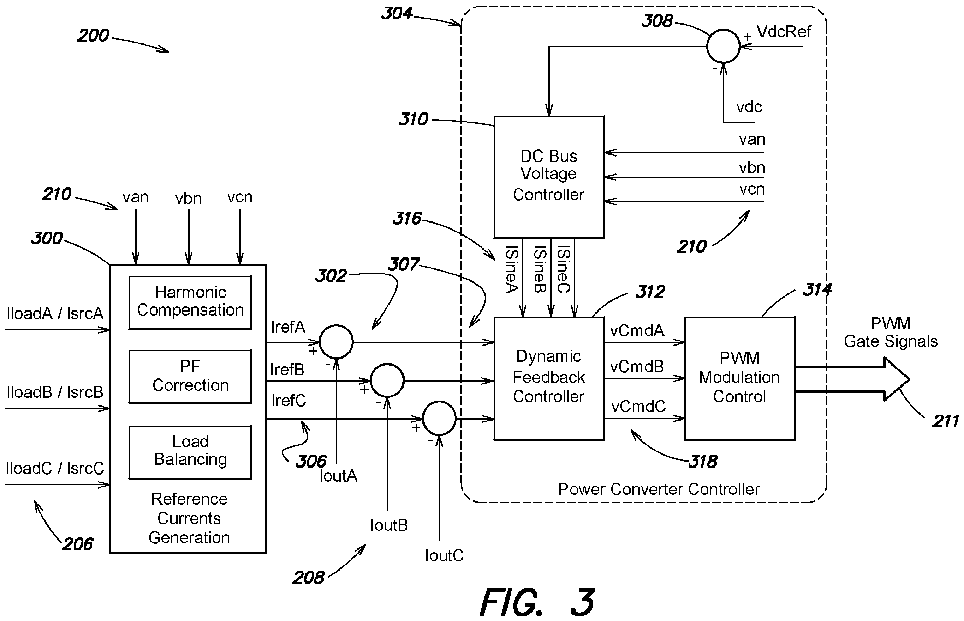

FIG. 3 illustrates a block diagram of the APF control circuitry 200. The APF control circuitry 200 includes reference current generator 300, a first error signal generator 302, and power converter control circuitry 304. The reference current generator 300 is configured to receive the system current signals 206 and the input and internal voltage measurement signals 210 and, based on the signals 206 and 210, generate reference current signals IrefA, IrefB, IrefC 306. For example, the reference current signals 306 may represent a target value of the signals 208.

The reference current generator 300 may be configured to generate the reference current signals IrefA, IrefB, IrefC 306 based on a neutral conductor connection status. For example, in one embodiment, when a neutral conductor is connected the reference current generator 300 may allow the reference current signals IrefA, IrefB, IrefC 306 to contain a zero component. When the neutral conductor is not connected, the reference current generator 300 may remove the zero component from the reference currents.

If the neutral conductor is disconnected, but reference currents contain a zero component, the APF control circuitry 200 may be unable to follow the reference current signals IrefA, IrefB, IrefC 306, which may result in instability or over-current trip. Conversely, if the neutral conductor is connected, but the zero component is incorrectly removed from the reference current signals IrefA, IrefB, IrefC 306, then the APF control circuitry 200 may provide incorrect compensation. Accordingly, it may be advantageous to correctly indicate a connection status of the neutral conductor to enable the reference current generator 300 to properly generate the reference current signals IrefA, IrefB, IrefC 306.

The first error signal generator 302 is configured to receive the reference current signals 306 and the output current signals 208, determine an error between each phase of the reference current signals 306 and the output current signals 208, and output error signals 307 to the power converter control circuitry 304. For example, the error signals 307 may be indicative of an error between IrefA and IoutA, IrefB and IoutB, and IrefC and IoutC of the signals 306 and 208, respectively.

The power converter control circuitry 304 is configured to receive the error signals 307 from the first error signal generator 302, analyze the error signals 307 to generate the one or more PWM gate signals 211, and output the PWM gate signals 211. The power converter control circuitry 304 includes an error signal generator 308, Direct Current (DC) bus voltage control circuitry 310, dynamic feedback control circuitry 312, and PWM modulation control circuitry 314.

The error signal generator 308 is configured to receive a DC current reference signal VdcRef and the DC bus voltage measurement Vdc of the input and internal voltage measurement signals 210. In one embodiment, the voltage measurement Vdc is indicative of a DC voltage on the one or more DC bus capacitors 212, and VdcRef is indicative of a target DC voltage for the voltage measurement Vdc. The error signal generator 308 determines a difference between the input voltages VdcRef and Vdc and outputs an error signal indicative of the difference between the input voltages VdcRef and Vdc to the DC bus voltage control circuitry 310.

The DC bus voltage control circuitry 310 is configured to regulate a DC voltage on the one or more DC bus capacitors 212. The DC bus voltage control circuitry 310 receives the error signal indicative of the difference between the input voltages VdcRef and Vdc, and receives the phase-neutral voltage signals Van, Vbn, Vcn of the input and internal voltage measurement signals 210. The phase-neutral voltage signals Van, Vbn, Vcn are respectively indicative of a voltage of the phase of the A-phase, B-phase, and C-phase conductors of the power lines 110 relative to the neutral conductor 112. In one example, the DC bus voltage control circuitry 310 generates, based on the received signals 210, 310, current signals IsineA, IsineB, IsineC 316 to regulate the DC voltage on the one or more DC capacitors 212, and provides the current signals 316 to the dynamic feedback control circuitry 312.

The dynamic feedback control circuitry 312 is configured to reduce an error between the output current signals 208 and the reference current signals 306 based on the output error signals 307 and the current signals 316. The dynamic feedback control circuitry 312 is configured to generate voltage command signals vCmdA, vCmdB, vCmdC 318 to control a voltage on each phase of the output power, and provide the voltage command signals 318 to the PWM modulation control circuitry 314.

The PWM modulation control circuitry 314 is configured to receive the voltage command signals 318 and determine, based on the voltage command signals 318, the one or more PWM gate signals 211. The PWM modulation control circuitry 314 provides the one or more PWM gate signals 211 to the PWM power converter 202, as discussed above.

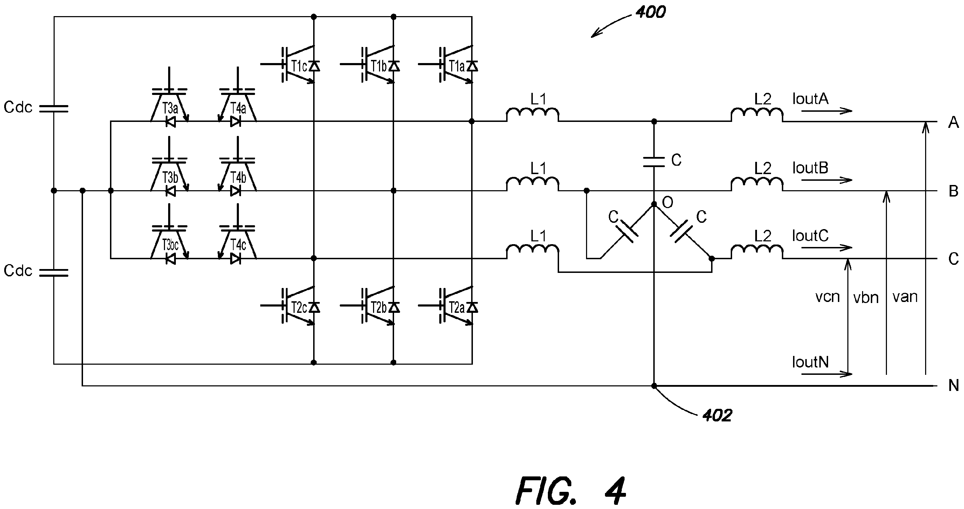

FIG. 4 illustrates a PWM power converter and filtering network 400. For example, the PWM power converter and filtering network 400 may be an implementation of the PWM power converter 202 coupled to the output filter 204. The PWM power converter and filtering network 400 is a 3-level T-type power converter coupled to a filtering network of inductors and capacitors, and is configured to be controlled by modulating respective states of a network of switching devices according to the PWM signals 211 received from the APF control circuitry 200. The PWM power converter and filtering network 400 includes a neutral point output 402. As discussed above, the neutral point output 402 may be connected or disconnected between a power source and a load.

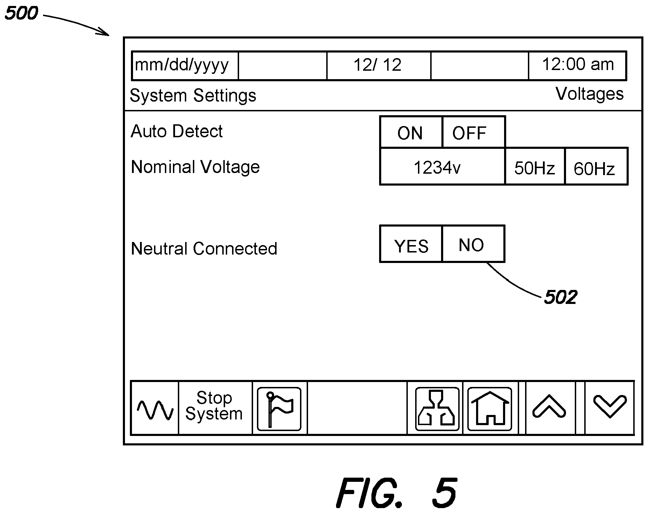

FIG. 5 illustrates a first screen of a Human Machine Interface (HMI) 500 that may be used with the APF 106 according to an embodiment. The first screen displays a System Settings screen, and the HMI 500 may be configured to display one or more alternate screens configured to display alternate information. The HMI 500 may be coupled to APF control circuitry, such as the APF control circuitry 200, and may enable a user to specify a neutral conductor connection status. For example, the HMI 500 may be used by a user to specify a connection status of the neutral point output 402. The HMI 500 may be mounted on a chassis containing the APF, or may be part of a separate device coupled to the APF through communication lines or through a wireless connection.

The first screen of the HMI 500 includes neutral connection status selections 502, which enable a user to indicate "YES," the neutral conductor of the APF is connected to the load, or "NO," the neutral conductor is not connected to the load. Responsive to a user selection of one of the neutral connection status selections 502, the APF may configure itself in accordance with the selection. The APF may independently determine if the user selection is consistent with an automatic detection of the user selection. As discussed above, a configuration of the neutral connection status may affect the generation of current reference signals by APF control circuitry, such as the reference current signals IrefA, IrefB, IrefC 306 by the APF control circuitry 200.

Accordingly, embodiments of the present disclosure enable detection of a neutral conductor connection status in an APF automatically without requiring a user selection. In one embodiment, a neutral conductor connection status may be detected using a power converter in the APF. For example, the power converter may attempt to inject a zero-component reference current value to reference currents generated by the power converter in the APF. The power converter may analyze the effect of the zero-component reference current on the reference currents generated by the power converter and determine, based on the analysis, the neutral conductor connection status of the APF. The APF may automatically configure one or more settings based on the determination, rather than configuring the one or more settings responsive to a user selection of a neutral conductor connection status.

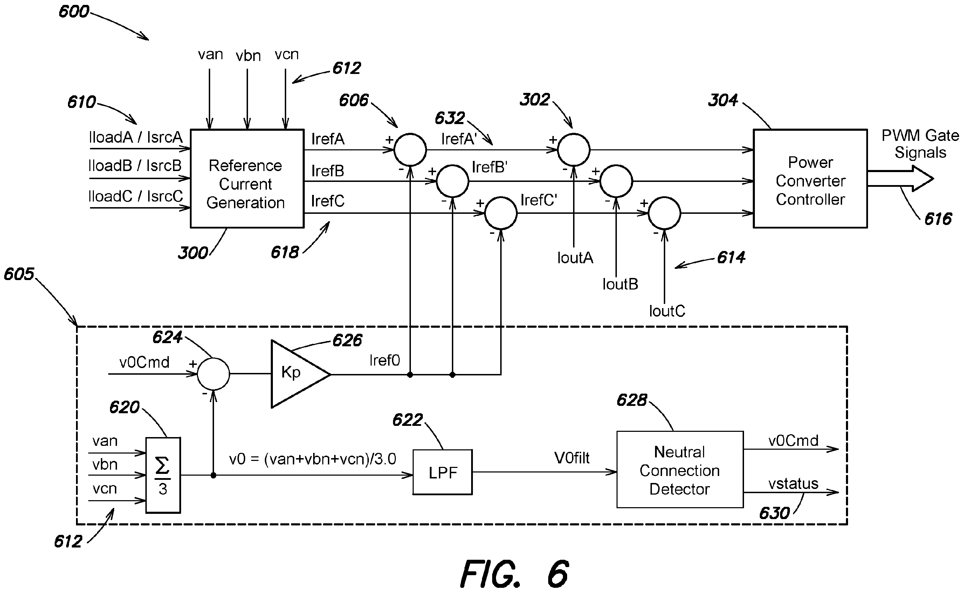

FIG. 6 illustrates a block diagram of APF control circuitry 600 used in the APF controller 200 of the APF 106 according to an embodiment. The APF control circuitry 600 includes a reference current generator 300, the first error generator 302, neutral connection detection circuitry 605, a second error generator 606, and a power converter controller 304. The APF control circuitry 600 is configured to receive load current signals IloadA, IloadB, IloadC or IsrcA, IsrcB, IsrcC 610, to receive output voltage signals van, vbn, vcn 612, and to receive output current signals IoutA, IoutB, IoutC 614, and is configured to output PWM gate signals 616.

The load current signals 610 are indicative of a current of each phase of power provided to a load. In one example, the load is provided with three-phase power, and the load current signals 610 are indicative of A-phase, B-phase, and C-phase current provided to the load. The load current signals 610 are provided to the reference current generator 300.

The output voltage signals 612 are indicative of a voltage of each phase of power provided by an APF coupled to the APF control circuitry 600. In one example, the APF provides three-phase power, and the load voltage signals 612 are indicative of A-phase, B-phase, and C-phase voltage provided by the APF to a load relative to neutral. The output voltage signals 612 are provided to the reference current generator 300.

The output current signals 614 are indicative of a phase current of each phase of compensation current provided by an APF coupled to the APF control circuitry 600. In one example, the APF provides three-phase power, and the output current signals 614 are indicative of A-phase, B-phase, and C-phase compensation current provided by the APF to a load. The output current signals 614 are provided to the first error generator 302.

The PWM gate signals 616 are configured to control switching operation of one or more switches. For example, the PWM gate signals 616 may be provided to one or more IGBTs in the PWM power converter 202. Controlling the switching operation of the one or more switches may include controlling an amount of compensation current provided to the load by the APF coupled to the APF control circuitry. In alternate embodiments, alternate switches may be implemented.

The second error generator 606 and the neutral connection detection circuitry 605 are configured to detect a neutral connection status of an APF by modifying a zero-voltage component v0 of the output voltage signals van, vbn, vcn 612. In one embodiment, modifying the zero-voltage component v0 includes injecting a zero-component reference current IrefD into the current reference signals IrefA, IrefB, IrefC 618. The zero-voltage component v0 is analyzed to determine an effect of the zero-component reference current IrefD on the zero-voltage component v0.

For example, analyzing the zero-voltage component v0 may include determining if the zero-voltage component v0 rises above a threshold value. If the zero-voltage component v0 exceeds the threshold value, then it may be determined that the neutral conductor is not connected. If the zero-voltage component v0 does not exceed the threshold value, then it may be determined that the neutral conductor is connected.

In one embodiment, the neutral connection detection circuitry 605 includes a zero-voltage module 620, a Low-Pass Filter (LPF) 622, a third error generator 624, a proportional gain controller 626, and a neutral connection detector 628. The neutral connection detection circuitry 605 is configured to receive the output voltage control signals van, vbn, vcn 612. The neutral connection detector 628 is configured to provide a neutral connection status signal vstatus 630 indicative of a neutral connection status.

The zero-voltage module 620 receives the output voltage control signals 612 and determines a zero-voltage component v0 of the output voltage control signals 612. For example, the zero-voltage module 620 may determine a summation of the output voltage control signals 612 and divide the sum by the number of output voltage control signals 612 to determine the zero-voltage component v0. Stated mathematically,

$$v0 = \frac{van + vbn + vcn}{3}$$

The zero-voltage module 620 outputs the zero-voltage component v0 to the LPF 622 and the third error generator 624. The third error generator 624 determines an error between the zero-voltage component v0 and a zero-voltage command component vOCmd provided by the neutral connection detector 628. For example, the zero-voltage command component vOCmd may be a square wave pulse. The third error generator 624 generates and outputs an error signal to the proportional gain controller 626. The proportional gain controller 626 generates a zero-current component reference current IrefD based on the error signal, and provides the zero-current component reference current IrefD to the second error generator 606.

The second error generator 606 receives the zero-current component reference current IrefD and the current reference signals IrefA, IrefB, IrefC 618, injects the zero-current component reference current Iref0 into the current reference signals IrefA, IrefB, IrefC 618 to produce modulated current reference signals IrefA', IrefB', IrefC' 632, and provides the modulated current reference signals IrefA', IrefB', IrefC' 632 to the first error generator 302. For example, injecting the zero-current component reference current Iref0 into the current reference signals IrefA, IrefB, IrefC 618 may include determining an error between the zero-current component reference current Iref0 and each respective current reference signal of the current reference signals IrefA, IrefB, IrefC 618 to produce the modulated current reference signals IrefA', IrefB', IrefC' 632.

The first error generator 302 determines an error between the modulated current reference signals IrefA', IrefB', IrefC' 632 and output current signals IoutA, IoutB, IoutC 614, and outputs an error signal to the power converter controller 304. The power converter controller 304 generates the PWM gate signals 616 based on the error signal and outputs the PWM gate signals 616.

The LPF 622 receives the zero-voltage component v0, filters out high-frequency components of the zero-voltage component v0 to generate filtered zero-voltage component v0filt, and provides the filtered zero-voltage component v0filt to the neutral connection detector 628. The neutral connection detector 628 analyzes the zero-voltage component v0filt to determine if a response to the zero-voltage command component vOCmd indicates that a neutral conductor is connected or disconnected. The neutral connection detector 628 outputs the neutral connection signal vstatus 630 indicative of the neutral connection status. The neutral connection signal vstatus 630 may be provided to the reference current generator 300 to generate the reference current signals IrefA, IrefB, IrefC 306.

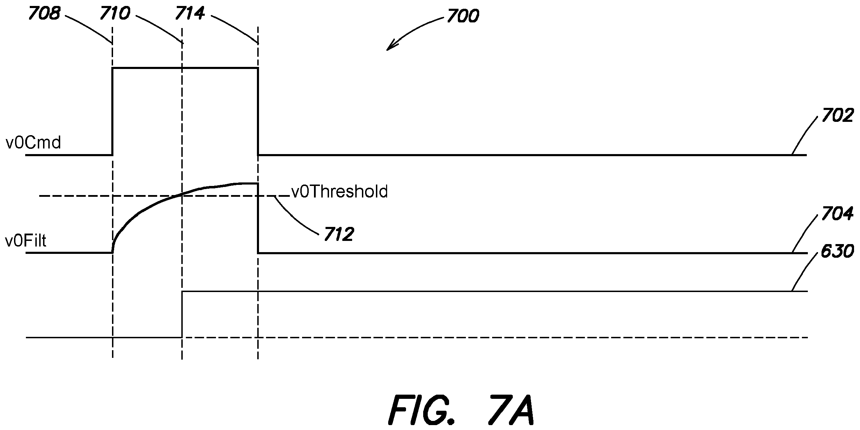

FIG. 7A illustrates a signal graph 700 of control signals sent and received by a neutral connection detector according to an embodiment. For example, the signal graph 700 may indicate control signals sent and received by the neutral connection detector 628 in an embodiment in which the neutral connection is disconnected.

The signal graph 700 includes a zero-voltage command component signal vOCmd 702, a filtered zero-voltage component signal v0filt 704, and the neutral connection signal vstatus 630. At a first time 708, the neutral connection detector 628 generates a square wave pulse as indicated by the zero-voltage command component signal vOCmd 702 and provides the signal vOCmd 702 to the third error generator 624. As discussed above, the signal V0Cmd 702 is propagated through the APF control circuitry 600 to modify the PWM gate signals 616, which affects the output voltage signals van, vbn, vcn 612. The filtered zero-voltage component signal v0filt 704 is consequently affected by the output voltage signals van, vbn, vcn 612.

In response to the signal vOCmd 702, the filtered zero-voltage component signal v0filt 704 begins to increase shortly after the first time 708. At a second time 710, the filtered zero-voltage component signal v0filt 704 exceeds a threshold voltage value vOThreshold 712. Exceeding the threshold voltage value vOThreshold 712 indicates that the neutral conductor is not connected. Accordingly, the neutral connection signal vstatus 630 transitions from a logical LOW value to a logical HIGH value to indicate that the neutral conductor is disconnected. At a third time 714, the zero-voltage command component signal vOCmd 702 and the filtered zero-voltage component signal v0filt 704 return to zero.

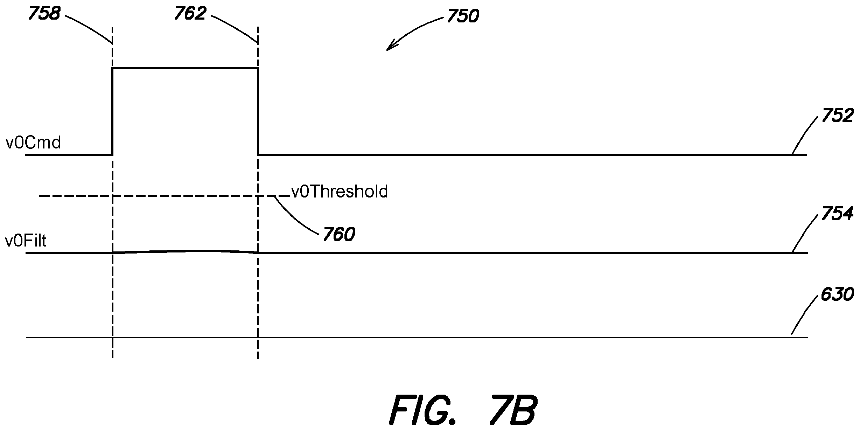

FIG. 7B illustrates a signal graph 750 of control signals sent and received by a neutral connection detector according to an embodiment. For example, the signal graph 750 may indicate control signals sent and received by the neutral connection detector 628 in an embodiment in which the neutral connection is connected.

The signal graph 750 includes a zero-voltage command component signal vOCmd 752, a filtered zero-voltage component signal v0filt 754, and the neutral connection signal vstatus 630. At a first time 758, the neutral connection detector 628 generates a square wave pulse as indicated by the zero-voltage command component signal vOCmd 752 and provides the signal vOCmd 752 to the third error generator 624. As discussed above, the signal V0Cmd 752 is propagated through the APF control circuitry 600 to modify the PWM gate signals 616, which affects the output voltage signals van, vbn, vcn 612. The filtered zero-voltage component signal v0filt 754 is consequently affected by the output voltage signals van, vbn, vcn 612.

In response to the signal vOCmd 752, the filtered zero-voltage component signal v0filt 754 experiences minor fluctuations. However, because the neutral conductor is connected, the effect of the signal vOCmd 752 on the filtered zero-voltage component signal v0filt 754 is relatively minor and the filtered zero-voltage component signal v0filt 754 does not increase to the voltage threshold vOThreshold 760. Accordingly, the neutral connection signal vstatus 630 remains at a logical LOW level to indicate that the neutral conductor is connected. At a second time 762, the zero-voltage command component signal vOCmd 752 and the filtered zero-voltage component signal v0filt 754 return to zero.

As discussed above, the neutral connection signal vstatus 630 is provided to control circuitry configured to select one or more configuration settings in accordance with the neutral conductor connection status. For example, selecting one or more configuration settings may include providing the neutral connection signal vstatus 630 to the reference current generator 300. The reference current generator 300 may determine, based on the neutral connection signal vstatus 630, whether to allow or remove a zero component from the reference current signals IrefA, IrefB, IrefC 306.

In some embodiments implementing the neutral connection detection circuitry 605, a user may still input a selection of a neutral connection status. For example, a user may select a neutral connection status using the neutral connection status selections 502 of the HMI 500. The neutral connection detection circuitry 605 may receive one or more signals indicative of the user's selection of the neutral connection status and compare the selection of the neutral connection status to the neutral connection status determined by the neutral connection detection circuitry 605 to determine if the statuses are the same, or if a discrepancy exists.

For example, if the neutral connection detector 628 determines that the neutral connection is connected, but a user indicates that the neutral connection is disconnected, then the neutral connection detection circuitry 605 may provide an output indicative of the discrepancy based on the comparison. The HMI 500 may display a message to a user indicating that there is a discrepancy between the determined neutral connection status and the neutral connection status specified by the user. Alternatively, if the neutral connection detector 628 determines, based on the comparison, that the statuses match, then the HMI 500 may display an indication that the statuses match.

In light of the foregoing, a method of detecting a neutral connection status of APF power converter circuitry has been disclosed. Responsive to determining the neutral connection status of the APF power converter circuitry, configuration settings may be automatically set in accordance with the neutral connection status without user intervention. Although FIG. 4 illustrates a particular implementation of a conventional PWM power converter and filtering network, in alternate embodiments, any PWM power converter topology including a neutral conductor may be analyzed to determine a connection status of the neutral conductor. Accordingly, the particular implementation of the PWM power converter discussed above is not intended to be limiting.

As discussed above, control circuitry such as the APF control circuitry 600 may control certain aspects of an APF such as the APF 106. Using data stored in associated memory, the APF control circuitry 600 also executes one or more instructions stored on one or more non-transitory computer-readable media that may result in manipulated data. In some examples, the APF control circuitry 600 may include one or more processors or other types of controllers. In one example, the APF control circuitry 600 performs a portion of the functions disclosed herein on a processor and performs another portion using an Application-Specific Integrated Circuit (ASIC) tailored to perform particular operations. As illustrated by these examples, examples in accordance with the present invention may perform the operations described herein using many specific combinations of hardware and software and the invention is not limited to any particular combination of hardware and software components.

Having thus described several aspects of at least one embodiment, it is to be appreciated various alterations, modifications, and improvements will readily occur to those skilled in the art. Such alterations, modifications, and improvements are intended to be part of this disclosure, and are intended to be within the scope of the disclosure. Accordingly, the foregoing description and drawings are by way of example only.

**Claims**

1. A power filter controller comprising:

   at least one input configured to:

      receive measurements of electrical characteristics of source power lines from a power source, wherein the source power lines include a first phase line, a second phase line, a third phase line and a neutral; and
      receive measurements of electrical characteristics of load power lines to a load, wherein the load power lines include a first phase line, a second phase line, a third phase line, and a neutral;

   an output configured to couple to a power converter coupled to the source power lines and the load power lines; and
   control circuitry coupled to the at least one input and the power converter, and configured to provide control signals to the power converter, wherein the control circuitry is configured to detect a connection status of a neutral connection to the load based on at least one of the measurements of the electrical characteristics of the source power lines and the measurements of the electrical characteristics of the load power lines, wherein the connection status includes one of connected and disconnected.

2. The power filter controller of claim 1, wherein the electrical characteristics of the load power lines include phase voltages, and wherein the control circuitry is configured to determine a value of a zero-voltage component of the load power lines, and detect the status of the neutral connection based on the value.

3. The power filter controller of claim 2, wherein the control circuitry is further configured to adjust the control signals to attempt to change the zero-voltage component, and detect the status of the neutral connection based on a resulting change in the zero-voltage component.

4. The power filter controller of claim 3, wherein the control circuitry is configured to adjust the control signals based on a comparison of the zero-voltage component and a reference zero-voltage command.

5. The power filter controller of claim 4, wherein the reference zero-voltage command includes a DC pulse.

6. The power filter controller of claim 1, wherein the power filter controller is coupled to a user interface configured to receive a neutral connection setting of the load from a user, and wherein the control circuitry is configured to receive the neutral connection setting of the load and compare the neutral connection setting of the load with the connection status of the neutral connection to obtain a comparison result, and provide an indication of the comparison result to the user interface.

7. The power filter controller of claim 1, wherein the control circuitry is configured to adjust the control signals based on the connection status of the neutral connection.

8. The power filter controller of claim 1, wherein the control circuitry is further configured to generate the control signals, based on the measurements of the electrical characteristics of the source power lines from the power source, to correct at least one of harmonic distortion, power factor, and load balance created by a load.

9. The power filter controller of claim 1, wherein the controls signals are pulse-width modulation signals, and wherein the pulse-width modulation signals control one or more switches in the power converter.

10. A method of operating a power filter to control characteristics of power from a power source to a load, the method comprising:

    receiving measurements of electrical characteristics of source power lines from the power source, wherein the source power lines include a first phase line, a second phase line, a third phase line and a neutral;

receiving measurements of electrical characteristics of load power lines to the load, wherein the load power lines include a first phase line, a second phase line, a third phase line and a neutral;

providing control signals to a power converter coupled to the source power lines and the load power lines; and

detecting a connection status of a neutral connection to the load, wherein the connection status includes one of connected and disconnected.

11. The method of claim 10, wherein the electrical characteristics of the load power lines include phase voltages, and wherein the method further includes determining a value of a zero-voltage component of the load power lines, and detecting the connection status of the neutral connection based on the value of the zero-voltage component.

12. The method of claim 11, further comprising adjusting the control signals to attempt to change the zero-voltage component, and detecting the connection status of the neutral connection based on a resulting change in the zero-voltage component.

13. The method of claim 12, further comprising adjusting the control signals based on a comparison of the zero-voltage component and a reference zero-voltage command.

14. The method of claim 13, wherein the reference zero-voltage command includes a DC pulse.

15. The method of claim 10, further comprising receiving a neutral connection setting of the load from a user via a user interface, comparing the neutral connection setting of the load with the connection status of the neutral connection to obtain a comparison result, and providing an indication on the user interface of the comparison result.

FIG. 1A

FIG. 1B

**FIG. 2**

FIG. 3

FIG. 4

EP 3 588 726 A1

EP 3 588 726 A1

500

| mm/dd/yyyy | | 12/ 12 | | 12:00 am |
|---|---|---|---|---|

| System Settings | Voltages |
|---|---|

| Auto Detect | ON | OFF | | |
|---|---|---|---|---|
| Nominal Voltage | 1234v | | 50Hz | 60Hz |

| Neutral Connected | YES | NO |
|---|---|---|

502

| ∿ | Stop System | ⚑ | | 🖧 | ⌂ | ⋀ | ⋁ |
|---|---|---|---|---|---|---|---|

FIG. 5

FIG. 6

EP 3 588 726 A1

FIG. 7A

FIG. 7B

EP 3 588 726 A1

Europäisches
Patentamt

European
Patent Office

Office européen
des brevets

# EUROPEAN SEARCH REPORT

Application Number

EP 19 18 2210

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | HOSSEINI S H ET AL: "Power quality enhancement using a new hybrid active power filter under non-ideal source and load conditions", POWER&ENERGY SOCIETY GENERAL MEETING, 2009. PES '09. IEEE, IEEE, PISCATAWAY, NJ, USA, 26 July 2009 (2009-07-26), pages 1-6, XP031538422, ISBN: 978-1-4244-4241-6 * line below equation (1); figures 1,2; table II * * abstract * | 1-15 | INV. H02J3/18 ADD. G01R31/04 G01R31/42 |
| Y | DE 10 2015 114452 A1 (SMA SOLAR TECHNOLOGY AG [DE]) 2 March 2017 (2017-03-02) * see references made for family member US 10 333 426 B2 * | 1-15 | |
| E | US 10 333 426 B2 (SMA SOLAR TECHNOLOGY AG [DE]) 25 June 2019 (2019-06-25) * figure 1 * * column 2, line 62 - column 3, line 62 * * column 7, line 67 - column 8, line 3 * * column 6, lines 7-15 * | 1-15 | TECHNICAL FIELDS SEARCHED (IPC) H02J H02M |

The present search report has been drawn up for all claims

| Place of search | Date of completion of the search | Examiner |
|---|---|---|
| Munich | 20 September 2019 | Varela Fraile, Pablo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 18 2210

This annex lists the patent family members relating to the patent documents cited in  the above-mentioned European search report.
The members are as contained in the European Patent Office EDP file on
The European Patent Office is in no way liable for these particulars which are merely given for the purpose of information.

20-09-2019

| Patent document cited in search report | Publication date | Patent family member(s) | | Publication date |
|---|---|---|---|---|
| DE 102015114452 A1 | 02-03-2017 | CN | 107925365 A | 17-04-2018 |
| | | DE | 102015114452 A1 | 02-03-2017 |
| | | EP | 3345294 A1 | 11-07-2018 |
| | | JP | 2018525965 A | 06-09-2018 |
| | | US | 2018191270 A1 | 05-07-2018 |
| | | WO | 2017036882 A1 | 09-03-2017 |
| US 10333426 B2 | 25-06-2019 | CN | 107925365 A | 17-04-2018 |
| | | DE | 102015114452 A1 | 02-03-2017 |
| | | EP | 3345294 A1 | 11-07-2018 |
| | | JP | 2018525965 A | 06-09-2018 |
| | | US | 2018191270 A1 | 05-07-2018 |
| | | WO | 2017036882 A1 | 09-03-2017 |

EPO FORM P0459

For more details about this annex : see Official Journal of the European Patent Office, No. 12/82